Europäisches Patentamt

**European Patent Office**

**Office européen des brevets**

(19)

(11) Veröffentlichungsnummer: **0 032 533**
A1

(12)

# EUROPÄISCHE PATENTANMELDUNG

(21) Anmeldenummer: **80106842.0**

(22) Anmeldetag: **06.11.80**

(51) Int. Cl.³: **H 03 G 3/30,** H 03 F 3/183, H 03 F 3/45

(30) Priorität: **19.12.79 DE 2951024**

(43) Veröffentlichungstag der Anmeldung: **29.07.81** Patentblatt 81/30

(84) Benannte Vertragsstaaten: **AT BE FR IT NL**

(71) Anmelder: **Licentia Patent-Verwaltungs-GmbH, Theodor-Stern-Kai 1, D-6000 Frankfurt/Main 70 (DE)**

(72) Erfinder: **Rall, Bernhard, Dipl.-Ing., Albecker Steige 67, D-7900 Ulm (DE)**

(74) Vertreter: **Schickle, Gerhard, Dipl.-Ing. et al, Licentia Patent-Verwaltungs-GmbH Theodor-Stern-Kai 1, D-6000 Frankfurt/Main 70 (DE)**

(54) **Verstärkerschaltung.**

(57) Zur Kompensation des Temperaturkoeffizienten dynamisch elektroakustischer Wandler in Endgeräten der Drahtnachrichtentechnik, insbesondere von Hörkapseln und Tauchspulenmikrofonen in Fernsprechgeräten wird für eine Verstärkerschaltung mit bipolaren integrierten Halbleiterverstärkerstufen vorgeschlagen, zwischen einer ersten Differenzverstärkerstufe (1) und einer daran angeschlossenen zweiten Verstärkerstufe (3) eine temperaturabhängige Gegenkopplungsschaltung (21) vorzusehen, deren Temperaturgang den des Wandlers über dem gesamten Betriebstemperaturbereich praktisch genau kompensiert. Hierfür ist eine Differenzverstärkerstufe (212, 214) besonders geeignet, da ihr vom Schleifenstrom (211) der Anschlußleitung (4, 5) gesteuerter Emittersummenstrom (213) zusätzlich die von der Länge der Anschlußleitung abhängige Signaldämpfung kompensiert.

ACTORUM AG

EP 0 032 533 A1

Licentia Patent-Verwaltungs-GmbH
Theodor-Stern-Kai 1
D-6000 Frankfurt 70

NE2-UL/Sar/lh
UL 79/131
Aktz.: P 29 51 024.5

Beschreibung

"Verstärkerschaltung"

Die Erfindung betrifft eine Verstärkerschaltung mit bipolaren integrierten Halbleiterverstärkerstufen für dynamische elektroakustische Wandler, vorzugsweise zum Einsatz in Endgeräten der Drahtnachrichtentechnik.

In elektronischen Endgeräten der Drahtnachrichtentechnik wie z. B. Fernsprechapparaten werden als elektroakustische Wandler vorwiegend Tauchspulmikrofone und dynamische Hörkapseln eingesetzt. Diese haben eine an einer Membran befestigte Tauchspule, die in dem Luftspalt eines Topfmagneten bewegbar angeordnet ist. Die Tauchspule besteht aus einer Kupferdrahtwicklung. Der elektrische Widerstand des Kupferdrahtes ist temperaturabhängig und nimmt um 0,4 %/°C zu. Die magnetische Flußdichte des Topfmagneten dagegen

0032533
UL 79/131

hat einen negativen Temperaturkoeffizienten von -0,2 %/$^{\circ}$C. Um von einer Hörkapsel bei Temperaturänderungen eine konstante Schalleistung zu erhalten, muß wegen der Abnahme der magnetischen Flußdichte bei Temperaturzunahme der Signalstrom durch die Tauchspule um 0,2 %/$^{\circ}$C zunehmen. Da gleichzeitig der Kupferwiderstand um 0,4 %/$^{\circ}$C steigt, nimmt bei konstanter Signalspannung an der Tauchspule der Signalstrom um 0,4 %/$^{\circ}$C ab, anstatt,wie es wegen der Abnahme der magnetischen Flußdichte wünschenswert ist, um 0,2 %/$^{\circ}$C zuzunehmen. Folglich muß für konstante Schalleistung bei konstanter Eingangsspannung eines Hörverstärkers dessen Verstärkung um 0,6 %/$^{\circ}$C zunehmen. Um diesen starken Temperaturgang der Hörkapsel zu mindern, wird in Reihe mit der Tauchspule ein Kohlewiderstand mit etwa gleich großem Widerstandswert wie der der Tauchspule geschaltet, der bekanntlich einen negativen Temperaturkoeffizienten hat. Infolge dieses zusätzlichen Widerstandes muß die Verstärkung des Hörverstärkers 6 dB höher sein. Für eine konstante Schalleistung braucht aber die Verstärkung nur noch um 0,3 %/$^{\circ}$C anzusteigen.

Aus der Literatur, z. B. dem Buch "Analog Integrated Circuit Design" von Grebene (1972), Seite 146 ist es bekannt, die Verstärkung eines Transistor-Differenzverstärkers über den gemeinsamen Emittergleichstrom, dem Emittersummenstrom, zu regeln. Es ist ferner aus dem gleichen Buche auf Seite 119 bekannt, die Temperaturabhängigkeit dieser Verstärkung dadurch auszugleichen, daß der Emittersummenstrom mittels einer sogenannten Thermometerschaltung proportional zur absoluten Temperatur gemacht wird. Die bekannten Maßnahmen sind jedoch ungeeignet, um einen positiven Temperaturgang der Verstärkung in der Höhe zu realisieren, wie es erforderlich ist, um den negativen Temperaturgang dynamischer elektroakustischer Wandler zu kompensieren.

Der Erfindung liegt daher die Aufgabe zugrunde, eine Verstärkerschaltung der eingangs genannten Art anzugeben, mit der es möglich ist, den Temperaturgang dynamischer elektroakustischer Wandler, insbesondere von Hörkapseln und dynamischer Mikrofonen von elektronischen Fernsprechapparaten, möglichst vollständig über den gesamten Betriebstemperaturbereich zu kompensieren. Dabei soll nach Möglichkeit versucht werden, die Lösung so zu gestalten, daß beim Einsatz der Verstärkerschaltung in Endgeräten der Drahtnachrichtentechnik auch die von der Länge der Teilnehmeranschlußleitung abhängigen Signaldämpfungen möglichst gut kompensiert werden können.

Die Aufgabe wird durch die im Anspruch 1 genannte Lösung bezüglich des Einflusses der Temperatur auf die Verstärkung gelöst. Vorteilhafte Weiterbildungen und Ausgestaltungen der Erfindung sind in den Unteransprüchen angegeben.

Die Ausgestaltung der Erfindung nach Anspruch 2 hat den Vorteil, daß der Einsatz einer Differenzverstärkerstufe als Gegenkopplungsschaltung mit temperaturunabhängigem Summenemitterstrom praktisch genau den erforderlichen Temperaturgang der Verstärkerschaltung ergibt. Diese Ausgestaltung bietet den weiteren Vorteil, daß durch Einstellen des Emittersummenstromes der als Gegenkopplungsschaltung dienenden Differenzverstärkerstufe die Verstärkung auf einen gewünschten Wert eingestellt werden kann. Dies kann über ein Stellglied oder bei aus der Teilnehmeranschlußleitung gespeistem Verstärker eines Endgerätes der Drahtnachrichtentechnik in vorteilhafter Weise durch den Schleifenstrom der Anschlußleitung erfolgen.

Die Ansprüche 5 und 6 geben vorteilhafte Ausgestaltungen der Erfindung bei ihrer Verwendung als Hörverstärker bzw. als Mikrofonverstärker.

Die Erfindung wird nun anhand von Zeichnungen und dort dargestellten Ausführungsbeispielen näher erläutert. Es zeigen im einzelnen:

FIG. 1 Schaltung eines Differenzverstärkers

FIG. 2 Blockschaltbild der erfindungsgemäßen Verstärkerschaltung

FIG. 3 Erfindungsgemäße Verstärkerschaltung für einen Hörverstärker

FIG. 4 Erfindungsgemäße Verstärkerschaltung für einen Mikrofonverstärker

FIG. 5 Schaltung einer temperaturabhängigen Stromquelle

FIG. 6 Schaltung der Arbeitspunktstabilisierung der Schaltung gemäß FIG. 3

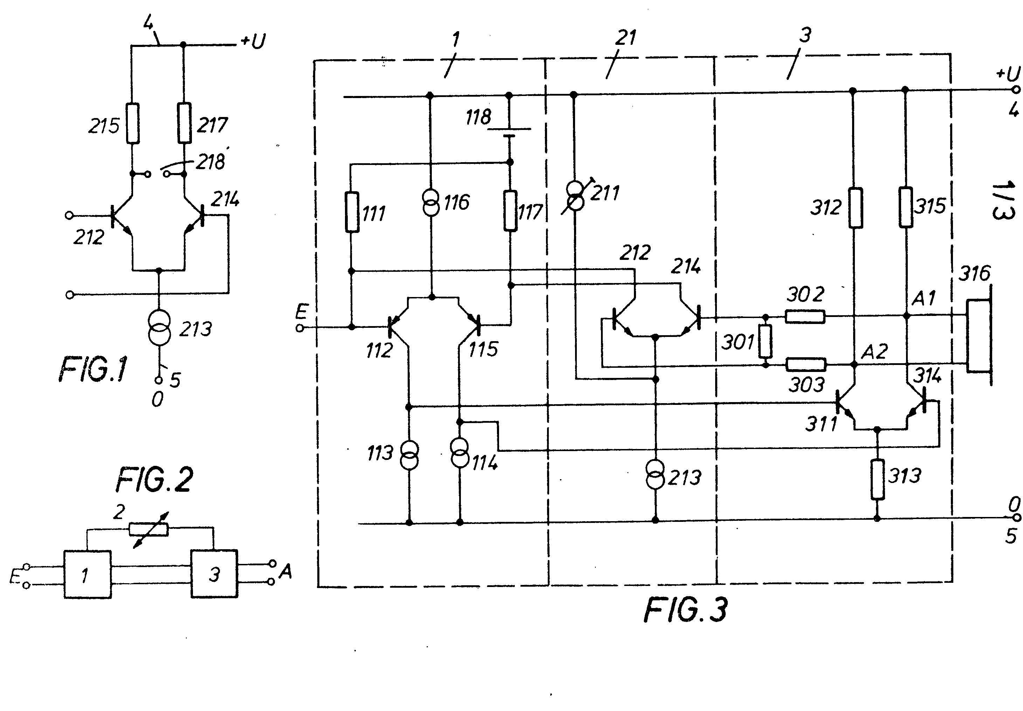

FIG. 1 zeigt die Schaltung eines Differenzverstärkers mit den beiden Transistoren 212 und 214, mit deren Arbeitswiderständen 215 und 217, die beide den gleichen Widerstandswert haben, und mit einer Stromquelle 213 zur Lieferung des Emittersummenstromes für die beiden Transistoren 212 und 214. Eine Betriebsspannung U liegt zwischen den Anschlüssen 4 und 5.

Die Basiselektroden der beiden Transistoren 212 und 214 bilden den Eingang und die Kollektorelektroden den Ausgang 218 des Differenzverstärkers.

Die Verstärkung A des Differenzverstärkers ist mit q = Elementarladung, k = Boltzmannkonstante, $R_{215} = R_{217}$ und T = absolute Temperatur

$$A = \frac{q}{2k} \cdot \frac{R_{215} \cdot I_{213}}{T} \qquad (1)$$

Soll die Verstärkung bei steigender Temperatur konstant bleiben, so muß folglich gemäß Gleichung 1 der Strom $I_{213}$ der Stromquelle 213 proportional der absoluten Temperatur T gemacht werden. Da eine Verstärkung mit positiven Temperaturkoeffizienten erforderlich ist, müßte $I_{213}$ mehr als proportional mit der Temperatur anwachsen, im vorliegenden Fall für einen Temperaturkoeffizienten der Verstärkung von 3 %/°C um 6 %/°C. Hierbei ergibt sich die Schwierigkeit, eine derart hohe Abhängigkeit des Stromes $I_{213}$ von der Temperatur zu erzielen.

Andererseits nimmt die Verstärkung des Differenzverstärkers bei konstantem Stromquellenstrom $I_{213}$ mit 1/T pro Grad Temperaturerhöhung ab. Bei 25°C beträgt der Temperaturkoeffizient somit etwa -0,33 %/°C.

Da in der Regel die Verstärkung einer einzelnen Verstärkerstufe nicht ausreicht, geht die Erfindung von dem Gedanken aus, die Verstärkerschaltung mehrstufig auszuführen und den Verstärkungsfaktor durch eine temperaturabhängige Gegenkopplung einzustellen.

In FIG. 2 ist das Blockschaltbild der prinzipiellen erfindungsgemäßen Lösung dargestellt. Zwischen einer ersten Differenzverstärkerstufe 1 und einem mit seinem Eingang an den Ausgang der ersten Differenzverstärkerstufe angeschlossenen zweiten Verstärkerstufe 3 ist eine temperaturabhängige Gegenkopplungsschaltung 2 vorgesehen. Als temperaturabhängige Gegenkopplung kann zur Erzielung eines positiven Temperaturganges der Verstärkerschaltung die Gegenkopplungsschaltung 2 beispielsweise aus einem Heißleiter evtl. mit parallel und in Reihe geschalteten ohmschen Widerständen zur gewünschten Einstellung des Temperaturganges und der Verstärkung bestehen.

Bei der Lösung der der Erfindung zugrundeliegenden Aufgabe hat es sich jedoch als besonders vorteilhaft herausgestellt, die Gegenkopplungsschaltung als Differenzverstärkerstufe mit temperaturunabhängigem Emittersummenstrom auszubilden, deren mindestens einer Eingang mit dem Ausgang der zweiten Verstärkerstufe 3 und dessen beide Ausgänge mit beiden Eingängen oder beiden Ausgängen der ersten Differenzverstärkerstufe 1 verbunden sind. Infolge des temperaturunabhängigen Emittersummenstromes besitzt dann die dritte Differenzverstärkerstufe gemäß Gleichung 1 einen negativen Temperaturkoeffizienten von etwa 0,33 %/$^{o}$C, so daß mit abnehmender Verstärkung der Gegenkopplungsschaltung bei Temperaturzunahme die Gesamtverstärkung der Schaltung in gewünschter Weise und in gewünschtem Maße, nämlich um 0,33 %/$^{o}$C, zunimmt.

Aus Gleichung 1 ist weiterhin ersichtlich, daß die Verstärkung eines Differenzverstärkers proportional dem Emittersummenstrom $I_{213}$ ist. Dieser Umstand wird bei der erfindungsgemäßen Verstärkerschaltung dazu ausgenutzt, um die Verstärkung der Verstärkerschaltung auf den jeweils gewünschten Wert einstellen zu können. Hierzu wird vorgeschlagen, den Emittersummenstrom der dritten Differenzverstärkerstufe einstellbar zu machen.

An zwei Ausführungsbeispielen sei die erfindungsgemäße Verstärkerschaltung weiter erläutert. In FIG. 3 ist zunächst eine Verstärkerschaltung eines Hörverstärkers dargestellt, der z. B. als Verstärker in einem aus der Anschlußleitung gespeisten Endgerät der Drahtnachrichtentechnik verwendet werden kann.

Die erste Differenzverstärkerstufe 1 umfaßt die Transistoren 112 und 115 mit den Stromquellen 116 für den Emittersummenstrom und 113 und 114 für den jeweiligen Kollektorstrom. Zur Basisvorspannung der beiden Transistoren dienen die Widerstände 111 und 117, die über eine Hilfsspannungsquelle 118 mit der positiven Leitung 4 der Betriebsspannungsquelle des Verstärkers verbunden sind.

Die Signalspannung wird in diesem Fall einpolig über die Eingangsklemme E der Basis des Transistors 112 zugeführt.

Am Ausgang der ersten Differenzverstärkerstufe 1, den beiden Kollektoren der Transistoren 112 und 115, ist eine zweite Differenzverstärkerstufe 3 mit den Transistoren 311 und 314 angeschlossen. Ihr Emittersummenstrom wird über den Widerstand 313 zugeführt. In ihren Kollektorleitungen liegen der Widerstand 312 bzw. 315 sowie die Ausgangsklemmen A1 und A2, an denen die Hörkapsel 316 angeschlossen ist. Die beschriebene Verstärkerschaltung ist bezüglich ihrer Arbeitspunktstabilisierung ausführlich in der DE-OS 29 31 525 beschrieben.

Die dritte Differenzverstärkerstufe, die gemäß der Erfindung als Gegenkopplungsschaltung vorgesehen ist, ist mit 21 bezeichnet und umfaßt die Transistoren 212 und 214 sowie die Stromquelle 213, die die Emitter der beiden Transistoren mit einem temperaturunabhängigen Emittersummenstrom versorgt. Die Differenzverstärkerstufe entspricht weitgehend der in FIG. 1 gezeigten. Sich entsprechende Schaltungsteile wurden daher mit den gleichen Bezugszeichen versehen.

In diesem Ausführungsbeispiel sind beide Eingänge, die Basiselektroden der Transistoren 212 und 214, mit dem Ausgang der zweiten Verstärkerstufe 3 verbunden. Zur Einstellung eines optimalen mittleren Gegenkopplungsgrades dienen die zwischen dem Eingang der dritten Differenzverstärkerstufe 21 und dem Ausgang der zweiten Verstärkerstufe 3 geschalteten Widerstände 301 bis 303. Die beiden Ausgänge der Differenzverstärkerstufe 21 sind mit beiden Eingängen der ersten Differenzverstärkerstufe 1 verbunden.

Das Ausführungsbeispiel zeigt ferner, daß der Emittersummenstrom $I_{213}$ durch eine weitere einstellbare oder veränderliche Stromquelle 211 abgeschwächt werden kann. Während die Stromquelle 213 zwischen der negativen Leitung 5 der Betriebsspannungsquelle und den zusammengeschalteten Emittern der Transistoren 212 und 214 liegt, ist die veränderbare oder veränderliche Stromquelle 211 zwischen den genannten Emittern und der positiven Leitung 4 der Betriebsspannungsquelle geschaltet. Wird daher der Strom durch die einstellbare Stromquelle 211 erhöht, so wird dieser Strom vom Strom der Stromquelle 213 subtrahiert, so daß die Transistoren der Differenzverstärkerstufe 21 weniger Strom erhalten. Gemäß Gleichung 1 sinkt dadurch die Verstärkung der Differenzverstärkerstufe 21, die Gegenkopplung wird folglich schwächer und damit die Verstärkung der Verstärkerschaltung zwischen dem Eingang E und der Hörkapsel 316 größer. Anstatt die Verstärkung über die Stromquelle 211 einstellbar zu machen, ist es für aus der Anschlußleitung gespeiste Verstärker eines Endgerätes der Drahtnachrichtentechnik von Vorteil, wenn der Emittersummenstrom der dritten Differenzverstärkerstufe 21 vom Schleifenstrom gesteuert ist. Je kürzer die Anschlußleitung ist, um so höher ist der Schleifenstrom und um so geringer muß die Verstärkung der Verstärkerschaltung sein. Im vorliegenden Fall muß der Strom durch die Stromquelle 211 umgekehrt proportional dem Schleifenstrom gesteuert werden. Ein großer Schleifenstrom bewirkt dann einen kleinen Strom 211, so daß der Emittersummenstrom der Transistoren 212 und 214 und damit deren Verstärkung groß ist. Die erhöhte Gegenkopplung bewirkt somit in gewünschter Weise eine reduzierte Verstärkung der Verstärkerschaltung.

0032533
UL 79/131

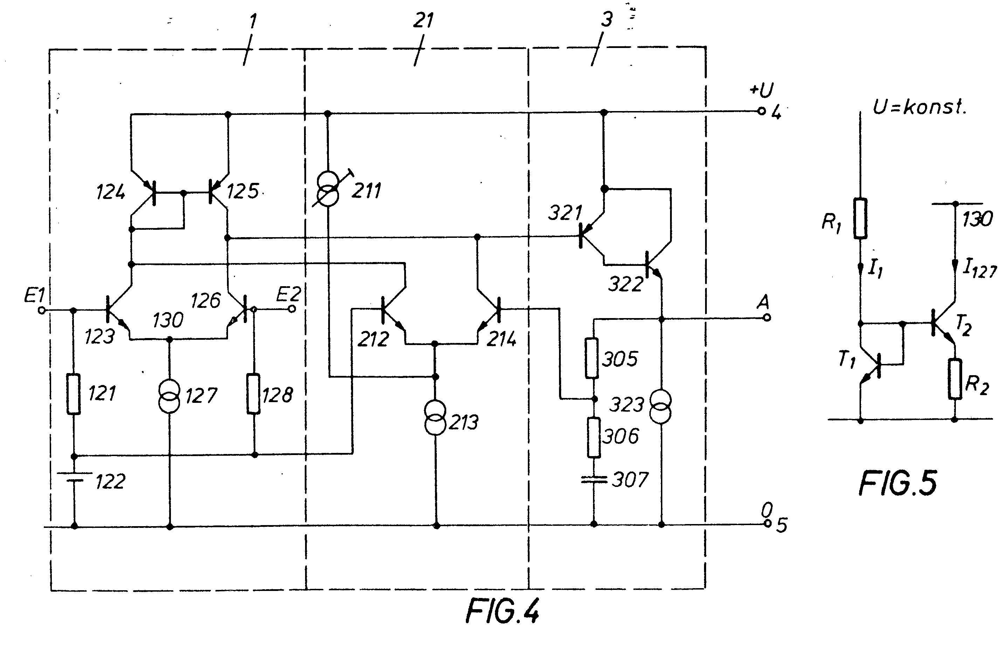

Ein weiteres Ausführungsbeispiel der erfindungsgemäßen Verstärkerschaltung ist in FIG. 4 dargestellt. Die Schaltung zeigt einen Verstärker für einen Wandler, der Schallenergie in elektrische Energie umwandelt. Ein derartiger Wandler ist z. B. ein in Fernsprechapparaten verwendbares Tauchspulmikrofon. Es wird an den Eingangsklemmen E1 und E2 der Verstärkerschaltung angeschlossen. Die erste Stufe 1 ist wiederum als Differenzverstärkerstufe ausgebildet und umfaßt die Transistoren 123 und 126, eine Stromquelle 127 für den Emittersummenstrom und Widerstände 121 und 128, die jeweils die Basisvorspannung den Transistoren 123 bzw. 126 zuführen, die einer Vorspannungsquelle 122 entnommen wird. Die Arbeitswiderstände in den Kollektorleitungen der Transistoren 123 und 126 sind als aktive Last ausgebildet und bestehen aus einem als Diode geschalteten Transistor 124 in der Kollektorleitung des Transistors 123 und einem an den Transistor 124 mit seiner Basis angeschlossenen Transistor 125, dessen hochohmige Kollektor-Emitter-Strecke den Arbeitswiderstand des Transistors 126 bildet. Die Transistoren 124 und 125 bilden eine an die positive Leitung 4 der Betriebsspannungsquelle angeschlossene Stromspiegelschaltung, die den Strom des Transistors 123 zum Kollektor des Transistors 126 spiegelt. Eine derartige Schaltung ist beispielsweise aus der Zeitschrift Funktechnik, JG. 30, 1975, H. 10, Seite 234, Bild 13 bekannt.

Als zweite Verstärkerstufe 3 ist eine Darlingtonendstufe gewählt. Sie umfaßt die komplementären Transistoren 321 und 322 mit der Stromquelle 323 als Arbeitswiderstand, an der das Ausgangssignal über den Anschluß A abgenommen werden kann. Die Gegenkopplungsschaltung 21 umfaßt wiederum die Transistoren 212 und 214 sowie die Stromquellen 213 und 211, von denen die Stromquelle 211 einstellbar oder

0032533
UL 79/131

vorzugsweise als vom Schleifenstrom gesteuert ausgeführt sein kann.

Wegen der einpoligen Ausgangsspannung ist in diesem Fall lediglich ein Eingang der dritten Differenzverstärkerstufe 21, die Basisleitung des Transistors 214, an die zweite Differenzverstärkerstufe 3 angeschlossen. Der andere Eingang, die Basisleitung des Transistors 212, ist mit der Vorspannungsquelle 122 der ersten Differenzverstärkerstufe 1 verbunden.

Zur Einstellung eines optimalen Gegenkopplungsgrades dient die Reihenschaltung aus den Widerständen 305 und 306 mit dem Kondensator 307 am Ausgang der zweiten Differenzverstärkerstufe 3, die parallel zur Stromquelle 323 geschaltet ist. Die Basisleitung des Transistors 214 der dritten Differenzverstärkerstufe 21 ist an den Verbindungspunkt der Widerstände 305 und 306 angeschlossen.

Infolge des Kondensators 307 wird die Gegenkopplung für Wechselstromsignale auf einen gewünschten Wert herabgesetzt, für Gleichstrom jedoch nicht, so daß die Arbeitspunktstabilisierung der Darlingtonendstufe 3 über die Gegenkopplungsschaltung 21 in vorteilhafter Weise voll wirksam ist und keine zusätzlichen Maßnahmen zur Arbeitspunktstabilisierung der Verstärkerschaltung erforderlich sind.

Als zweckmäßig hat sich bei diesem Ausführungsbeispiel herausgestellt, je einen Ausgang der dritten Differenzverstärkerstufe 21 statt mit je einem Eingang mit je einem Ausgang der ersten Differenzverstärkerstufe 1 zu verbinden. Die Einspeisung des Gegenkopplungsstromes der dritten Differenzverstärkerstufe 21 auf die Eingänge E1 und E2 der ersten Differenzverstärkerstufe ist hier aus Rauschgründen nicht zweckmäßig. Aus diesem Grunde ist auch der Strom der Stromquelle 127 der ersten Differenzverstärkerstufe etwa 3mal so groß zu wählen wie der der Stromquelle 213 der dritten Differenzverstärkerstufe. Die erste Differenzverstärkerstufe wird somit von der Gegenkopplungsschleife nicht erfaßt und wird getrennt mit optimalen Arbeitsbedingungen bezüglich Arbeitspunkt und Symmetrie des Eingangswiderstandes betrieben.

Bei temperaturunabhängigen Strömen 127, 211 und 213 zeigt die Verstärkerschaltung nach FIG. 4 keinen Temperaturgang, da beide Verstärkerstufen 1 und 21 parallel auf den Ausgang der ersten Differenzverstärkerstufe 1, den Kollektoren der Transistoren 123 und 126, arbeiten und gleichlaufende Temperaturgänge aufweisen. Eine temperaturabhängige Verstärkungszunahme der ersten Differenzverstärkerstufe 1 wird nämlich durch die Verstärkungszunahme der gegenkoppelnden dritten Differenzverstärkerstufe 21 kompensiert. Daher ist es hier zweckmäßig, der Stromquelle 127 der Verstärkerstufe 1, wegen des negativen Temperaturkoeffizienten des Tauchspulenmikrofons von -0,2 %/$^{\circ}$C, einen positiven Temperaturkoeffizienten von +0,2 %/$^{\circ}$C zu geben. Damit hat auch der Gesamtverstärker den gewünschten positiven Temperaturkoeffizienten von +0,2 %/$^{\circ}$C.

Als Stromquelle mit einem Temperaturkoeffizienten von 0,2 %/$^{\circ}$C kann beispielsweise eine Transistorschaltung verwendet werden, wie sie in FIG. 5 dargestellt ist. Der durch den Vorwiderstand $R_1$ in eine Stromspiegelschaltung eingespeiste Strom $I_1$ bewirkt bei einem Emitterwiderstand $R_2 = 0$ des Transistors $T_2$ einen temperaturunabhängigen Strom $I_{127}$ und bei einem endlichen Widerstand $R_2$ einen Temperaturkoeffizienten des Stromes $I_{127}$ von etwa 0,34 %/$^{\circ}$C.

Wird nun für den Widerstand $R_2$ ein solcher mit einem Temperaturgang von 0,14 %/$^O$C gewählt, so beträgt der Temperaturkoeffizient des Stromes der Stromquelle 127 ziemlich genau 0,2 %/$^O$C.

Über die einstellbare oder vom Schleifenstrom steuerbare Stromquelle 211 in FIG. 4 sind Verstärkungsänderungen im Verhältnis 3:1, wie sie in elektronischen Fernsprechapparaten gefordert werden, unschwer einstellbar, wobei keine zusätzlichen Klirrverzerrungen entstehen, weil die Gegenkopplung stets symmetrisch am Ausgang der ersten Differenzverstärkerstufe 1 angreift.

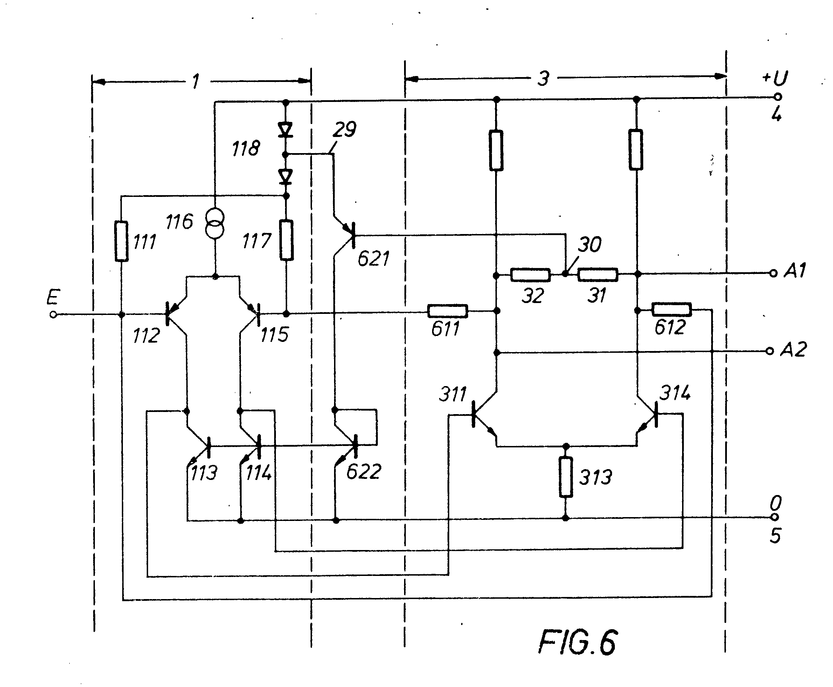

Die Arbeitspunktstabilisierung des in FIG. 3 dargestellten Ausführungsbeispiels ohne Gegenkopplungsdifferenzverstärker zeigt FIG. 6. Gleiche Bauteile sind mit gleichen Bezugszeichen versehen. Zusätzliche Bezugszeichen betreffen zusätzliche Bauteile zur Arbeitspunktstabilisierung. Die Funktion der Schaltung ist ohne weiteres der FIG. 6 entnehmbar und in der DE-OS 29 31 525 ausführlich beschrieben.

Abschließend sei noch zu FIG. 4 eine weitere vorteilhafte Variante zur Einstellung eines gewünschten Temperaturkoeffizienten eines Stromes genannt. Diese Variante sieht vor, einen temperaturunabhängigen Strom mit einem stark temperaturabhängigen Strom zu vereinen.

Beispielsweise ist bei einer Schaltung gemäß FIG. 5 für $R_2$ = 0 der Strom $I_{127}$ temperaturunabhängig und für einen Spannungsabfall $I_{127} \cdot R_2 >$ 25 mV mit einem temperaturunhängigen Widerstand $R_2$ liegt der Temperaturkoeffizient des Stromes $I_{127}$ im Grenzfall bei etwa 0,34 %/$^O$C. Durch kollektorseitiges Parallelschalten der Transistoren $T_2$ (FIG. 5), die beide mit ihren Basisanschlüssen am Kollektor des Transistors T1 angeschlossen sind, von denen jedoch der eine einen Widerstand $R_2$, der andere aber keinen Widerstand in der Emitterzuleitung hat, läßt sich über die Höhe des Widerstandswertes des Widerstandes $R_2$ und/oder des Flächenverhältnisses der Kollektorflächen der Transistoren T2 ein Strom der gewünschten Höhe und des gewünschten Temperaturkoeffizienten, im Ausführungsbeispiel von +0,2 %/$^\circ$C, erzielen.

0032533

Licentia Patent-Verwaltungs-GmbH
Theodor-Stern-Kai 1
D-6000 Frankfurt 70

NE2-UL/Sar/lh
UL 79/131
Aktz.: P 29 51 024.5

## Patentansprüche

1. Verstärkerschaltung mit bipolaren integrierten Halbleiterverstärkerstufen für dynamische elektroakustische
Wandler, vorzugsweise zum Einsatz in Endgeräten der Drahtnachrichtentechnik, dadurch gekennzeichnet, daß zwischen
einer ersten Differenzverstärkerstufe (1) und einer mit
ihrem Eingang an den Ausgang der ersten Differenzverstärkerstufe angeschlossenen zweiten Verstärkerstufe (3), eine temperaturabhängige Gegenkopplungsschaltung (2) vorgesehen ist.

2. Schaltung nach Anspruch 1, dadurch gekennzeichnet, daß
die Gegenkopplungsschaltung (2) eine dritte Differenzverstärkerstufe (21) ist, deren mindestens einer Eingang mit
dem Ausgang der zweiten Verstärkerstufe (3) und dessen
beide Ausgänge mit beiden Eingängen oder beiden Ausgängen
der ersten Differenzverstärkerstufe (1) verbunden sind.

- 15 -

<-> zur Kompensation des Temperaturganges des Wandlers

3. Schaltung nach Anspruch 2, dadurch gekennzeichnet, daß der Emittersummenstrom der dritten Differenzverstärkerstufe (21) einstellbar ist.

4. Schaltung nach Anspruch 2 für den Fall eines aus der Anschlußleitung gespeisten Verstärkers eines Endgerätes der Drahtnachrichtentechnik, dadurch gekennzeichnet, daß der Emittersummenstrom der dritten Differenzverstärkerstufe (21) vom Schleifenstrom gesteuert ist.

5. Schaltung nach einem der Ansprüche 2 bis 4 für den Fall seiner Verwendung als Verstärker für einen Wandler, der elektrische Energie in hörbaren Schall umwandelt, dadurch gekennzeichnet, daß je ein Ausgang der dritten Differenzverstärkerstufe (21) mit je einem Eingang der ersten Differenzverstärkerstufe (1) verbunden ist und für den Emittersummenstrom der dritten Differenzverstärkerstufe (21) eine Stromquelle (213) mit temperaturunabhängigem Strom vorgesehen ist.

6. Schaltung nach einem der Ansprüche 2 bis 4 für den Fall seiner Verwendung als Verstärker für einen Wandler, der Schallenergie in elektrische Energie umwandelt, dadurch gekennzeichnet, daß je ein Ausgang der dritten Differenzverstärkerstufe (21) mit je einem Ausgang der ersten Differenzverstärkerstufe (1) verbunden ist und für den Emittersummenstrom der ersten Differenzverstärkerstufe (1) eine Stromquelle (127) mit positivem Temperaturkoeffizienten vorgesehen ist.

FIG.1

FIG.2

FIG.3

1/3

0032533

FIG.5

FIG.4

FIG.6

| Kategorie | Kennzeichnung des Dokuments mit Angabe, soweit erforderlich, der maßgeblichen Teile | betrifft Anspruch |
|---|---|---|
| | **EINSCHLÄGIGE DOKUMENTE** | |
| | DE - B - 2 143 413 (MATSUSHITA) | 1, 2 |
| | * Figur 3; Spalte 5, Zeile 3 bis Spalte 6, Zeile 8 * | |
| | --- | |
| | US - A - 3 845 404 (T.R. TRILLING) | 1-3, 5 |
| | * Figuren 1,2b,13,16; Spalte 1, Zeile 43 bis Spalte 2, Zeile 8; Spalte 10, Zeilen 5-54 * | |
| | --- | |
| | DE - B - 1 541 546 (R.C.A.) | 1-3 |
| | * Figuren; Spalte 2, Zeile 39 bis Spalte 4, Zeile 49 * | |
| | --- | |
| | DE - A - 2 531 208 (PHILIPS) | 1 |
| | * Figuren 2,3; Seite 10, Zeile 12 bis Seite 12, Zeile 8 * | |
| | --- | |
| | DE - A - 2 402 801 (R. BOSCH) | 1 |
| | * Figur 1; Seite 5, Zeile 16 bis Seite 10, Zeile 18 * | |
| | --- | |
| | US - A - 3 542 952 (C.S. WANG) | 1, 4 |
| | * Figuren 4-6; Spalte 5, Zeile 30 bis Spalte 6, Zeile 38 * | |
| | --- | ./. |

KLASSIFIKATION DER ANMELDUNG (Int. Cl.³)

H 03 G 3/30
F 3/183
3/45

RECHERCHIERTE SACHGEBIETE (Int. Cl.³)

H 03 G 3/
H 03 F 3/
H 03 F 1/

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recnerchenbericht wurde für alle Patentansprüche erstellt. |
|---|---|

| Recherchenort | Abschlußdatum der Recherche | Prüfer |
|---|---|---|
| Den Haag | 19-03-1981 | TYBERGHIEN |

EPA form 1503.1 06.78

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | US – A – 3 440 352 (H.J. BOLL)<br><br>* Figuren; Spalte 2, Zeilen 54-67; Spalte 1, Zeilen 13-16 *<br><br>--- | 1 | |
| P | DE – A – 2 947 771 (NIPPON GAKKI SEIZO)<br><br>* Figuren 1-3; Seite 9, Zeilen 9-30; von Seite 12, Zeile 20 bis Seite 14, Zeile 4 *<br><br>--- | 1, 2, 5 | |
| P | DE – A – 2 928 841 (PLONEER)<br><br>* Figuren 1,3,4; von Seite 5, Zeile 1 bis Seite 6, Zeile 24; Seite 10, Zeilen 4-13 *<br><br>--- | 1 | RECHERCHIERTE SACHGEBIETE (Int. Cl. 3) |
| P | DE – A – 2 922 693 (VEB FERNMELDE-WERK)<br><br>* Figuren 1,2; von Seite 6, Zeile 25 bis Seite 7, Zeile 15 * | 1 | |